**Europäisches Patentamt**

(19) **European Patent Office**

**Office européen des brevets**

(11) Veröffentlichungsnummer: **0 142 079**
**B1**

(12) **EUROPÄISCHE PATENTSCHRIFT**

(45) Veröffentlichungstag der Patentschrift:
**07.10.87**

(21) Anmeldenummer: **84112819.2**

(22) Anmeldetag: **24.10.84**

(51) Int. Cl.⁴: **G 01 N 24/04,** G 01 N 24/08

(54) Hochfrequenz-Einrichtung einer Kernspinresonanz-Apparatur.

(30) Priorität: **08.11.83 DE 3340337**

(43) Veröffentlichungstag der Anmeldung:
**22.05.85 Patentblatt 85/21**

(45) Bekanntmachung des Hinweises auf die Patenterteilung:
**07.10.87 Patentblatt 87/41**

(84) Benannte Vertragsstaaten:
**DE FR GB NL**

(56) Entgegenhaltungen:
**GB - A - 2 056 086**
**GB - A - 2 082 775**
**GB - A - 2 094 482**
**US - A - 3 953 789**
**US - A - 4 411 270**

(73) Patentinhaber: **Siemens Aktiengesellschaft Berlin und München, Wittelsbacherplatz 2, D-8000 München 2 (DE)**

(72) Erfinder: **Krause, Norbert, Dr., Weinbergstrasse 29, D-8551 Heroldsbach (DE)**

**Beschreibung**

Die Erfindung bezieht sich auf eine Einrichtung zur Erzeugung eines magnetischen Hochfrequenz-Feldes und/oder zum Empfangen von entsprechenden Hochfrequenz-Signalen in einer Kernspinresonanz-Apparatur, insbesondere der medizinischen Technik, mit einer Hochfrequenz-Spulenwicklung, welche innerhalb eines zumindest teilweise homogenen Magnetfeldbereiches des von einem Grundfeldmagneten erzeugten, längs einer Achse orientierten Magnetfeldes entweder unmittelbar auf einem zu untersuchenden Körper oder Körperteil oder zumindest in der Nähe desselben anzuordnen ist. Eine derartige Hochfrequenz-Einrichtung geht z.B. aus Berichten des «Second Annual Meeting of the Society of Magnetic Resonance in Medicine», Aug. 16.-19., 1983, San Francisco, USA (vgl. insbesondere Seiten 16 und 17, 53 und 54 oder Seiten 83 und 84) hervor.

Insbesondere auf dem Gebiet der medizinischen Technik sind Diagnoseverfahren entwickelt worden, bei denen rechnerisch oder messtechnisch integrale Resonanzsignale von Kernen eines bestimmten Elementes aus der Spindichteverteilung und/oder aus der Relaxationszeitenverteilung eines zu untersuchenden Körpers bzw. Körperteiles analysiert werden. Entsprechende Verfahren sind unter der Bezeichnung «Kernspintomographie» (Nuclear Magnetic Resonance Tomography) oder «Zeugmatographie» bekannt.

Voraussetzung für die Kernspintomographie ist ein von einem sogenannten Grundfeldmagneten erzeugtes starkes Magnetfeld, das in einem Bereich vorbestimmter Ausdehnung möglichst homogen ist und in das der zu untersuchende Körper bzw. der Körperteil längs einer Achse, die im allgemeinen mit der Orientierungsachse des magnetischen Grundfeldes übereinstimmt, eingebracht wird. Zur Anregung der Atomkerne eines vorbestimmten Elementes in dem Körper zu einer Präzessionsbewegung ist ausserdem eine besondere Spulenwicklung erforderlich, mit der kurzzeitig ein hochfrequentes magnetisches Wechselfeld erzeugt werden und die auch zum Empfang der damit verbundenen Hochfrequenz-Signale dienen kann, falls keine besondere Messspulenwicklung vorgesehen wird. Gegebenenfalls kann das Grundfeld auch lokal variiert werden, um damit den Bereich, der durch das Signal der Spulenwicklung angeregt wird, auf eine vorbestimmte Ausdehnung zu beschränken (Topological NMR; Sensitive Point Method).

Sollen beispielsweise die im menschlichen Körper im Vergleich zu $^1$H-Kernen verhältnismässig wenig auftretenden $^{31}$P-Kerne oder $^{13}$C-Kerne angeregt bzw. deren Kernspinresonanz-Signale empfangen werden, so müssen Hochfrequenz-Spulenwicklungen vorgesehen werden, die aus Gründen einer ausreichend grossen Empfindlichkeit in oberflächennahen Körperbereichen angeordnet, d.h. insbesondere auf die Körperoberfläche aufgelegt werden können. Als hierfür geeignete Hochfrequenz-Spulenwicklungen, die auch als Oberflächenspulen bezeichnet werden, benutzt man kreisringförmige Wicklungen mit einer oder auch mehreren Windungen (vgl. die eingangs genannten Berichte). Bei entsprechenden Resonanzexperimenten ergibt sich nun, dass aufgrund der Wirkung des erforderlichen starken magnetischen Grundfeldes die Komponenten des sehr viel kleineren hochfrequenten Magnetfeldes, welche mit der Richtung des Grundfeldes übereinstimmen, praktisch unwirksam sind. Dies hat zur Folge, dass die Empfindlichkeit einer solchen Ringspule in der Ebene parallel zum statischen Grundfeld von der Empfindlichkeit in der dazu senkrechten Ebene in verhältnismässig unübersichtlicher, komplizierter Weise verschieden ist. Hieraus ergeben sich Schwierigkeiten bezüglich der örtlichen Zuordnung der mit der Ringspule empfangenen Signale.

Aufgabe der vorliegenden Erfindung ist es deshalb, die eingangs genannte Einrichtung dahingehend zu verbessern, dass mit ihr genauere Aussagen über die örtliche Lage der zu detektierenden Atomkerne in dem zu untersuchenden Körper bzw. Körperteil gemacht werden können.

Diese Aufgabe wird erfindungsgemäss dadurch gelöst, dass die Hochfrequenz-Spulenwicklung im wesentlichen eine rechteckige Gestalt aufweist, wobei deren mindestens zwei parallel verlaufende Längsleiterstücke wesentlich länger ausgebildet sind als die sie verbindenden, dazu quer verlaufenden Querleiterstücke, und dass die Längsleiterstücke zumindest weitgehend senkrecht zur Hauptorientierungsrichtung des Magnetfeldes des Grundfeldmagneten angeordnet sind.

Die mit dieser Ausgestaltung der Einrichtung verbundenen Vorteile sind insbesondere darin zu sehen, dass — aufgrund der Rechteckform der Hochfrequenz-Spulenwicklung und der besonderen Ausrichtung ihrer Längsleiterstücke — in jeder Querschnittsebene Eyz parallel zum Grundfeld und senkrecht zur Körperoberfläche annähernd die gleiche Feldcharakteristik bei der Abstrahlung der Hochfrequenz-Signale ausgebildet wird. Entsprechendes gilt auch für den Empfangsteil. Es lässt sich dann erreichen, dass die empfangenen Hochfrequenz-Signale eindeutiger einem Bereich zuzuordnen sind, der durch die geometrische Ausdehnung der Fläche zwischen den Längsleiterstücken der Hochfrequenz-Spulenwicklung begrenzt wird.

Vorteilhafte Ausgestaltungen der erfindungsgemässen Hochfrequenz-Einrichtung gehen aus den Ansprüchen 2 bis 4 hervor.

Die Erfindung wird nachfolgend anhand der Zeichnung noch weiter erläutert. Dabei zeigt Fig. 1 schematisch die Anordnung einer bekannten Hochfrequenz-Spulenwicklung, während in den Diagrammen der Fig. 2 und 3 der dazugehörige Verlauf von Linien konstanter wirksamer magnetischer Wechselfeldstärke in zwei verschiedenen Schnittebenen wiedergegeben ist. In entsprechender Darstellung gehen aus den Fig. 4 bis 6 eine Hochfrequenz-Spulenwicklung für eine erfindungsgemässe Einrichtung bzw. die sich bei dieser Wicklung ergebenden Feldstärkeverhältnisse hervor.

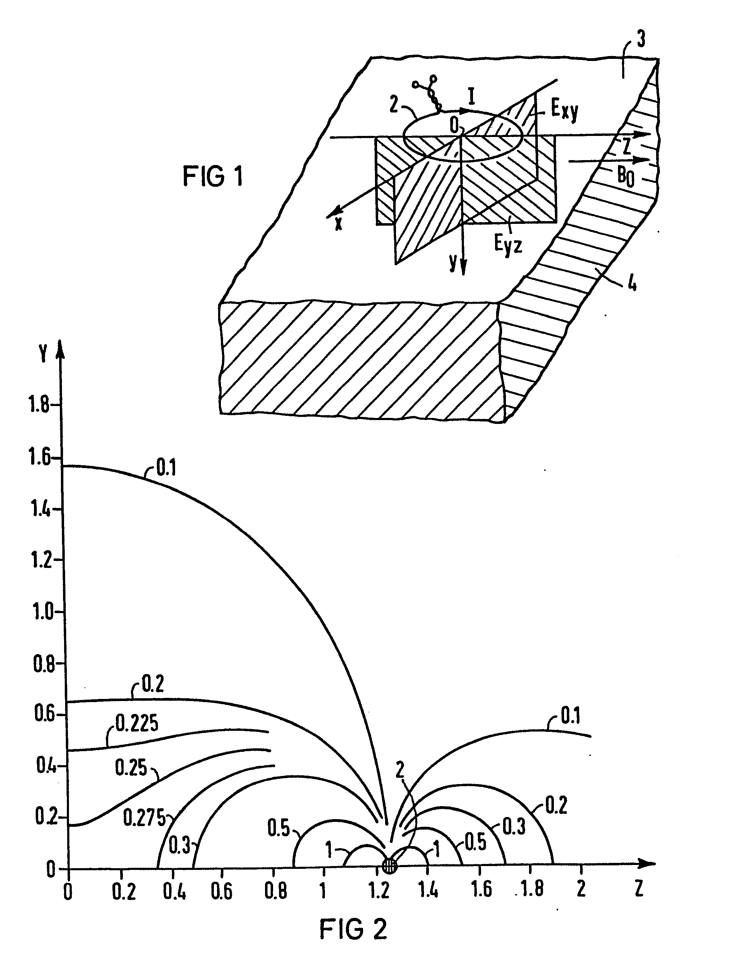

Fig. 1 zeigt eine bekannte Ringspule 2 mit beispielsweise einer Windung, die konzentrisch um einen Punkt O auf die Oberfläche 3 eines zu untersuchenden Körpers oder Körperteiles 4 aufgelegt ist. Dieser Körperteil ist in bekannter Weise in ein zumindest teilweise homogenes magnetisches Grundfeld

$\vec{B_0}$ eines entsprechenden Magneten einer in der Figur nicht dargestellten Kernspinresonanz-Apparatur eingebracht. Durch den Punkt 0 ist ein rechtwinkliges x-y-z-Koordinatensystem so gelegt, dass die z-Achse in die Orientierungsrichtung des magnetischen Grundfeldes $\vec{B_0}$ weist. Ausserdem sind in der Figur die x-y-Ebene und die y-z-Ebene näher veranschaulicht und mit $E_{xy}$ bzw. $E_{yz}$ bezeichnet. Mit Hilfe eines hochfrequenten Wechselstromes I durch die Ringspule 2 wird dann ein für entsprechende Resonanzexperimente erforderliches kurzzeitiges Hochfrequenz-Feld der Feldstärke $B_1$ erzeugt. Die Ringspule kann hierbei auch als Empfänger für die nach dem Abschalten des Hochfrequenz-Feldes zu empfangenden Hochfrequenz-Signale aus dem Inneren des Körperteiles 4 dienen.

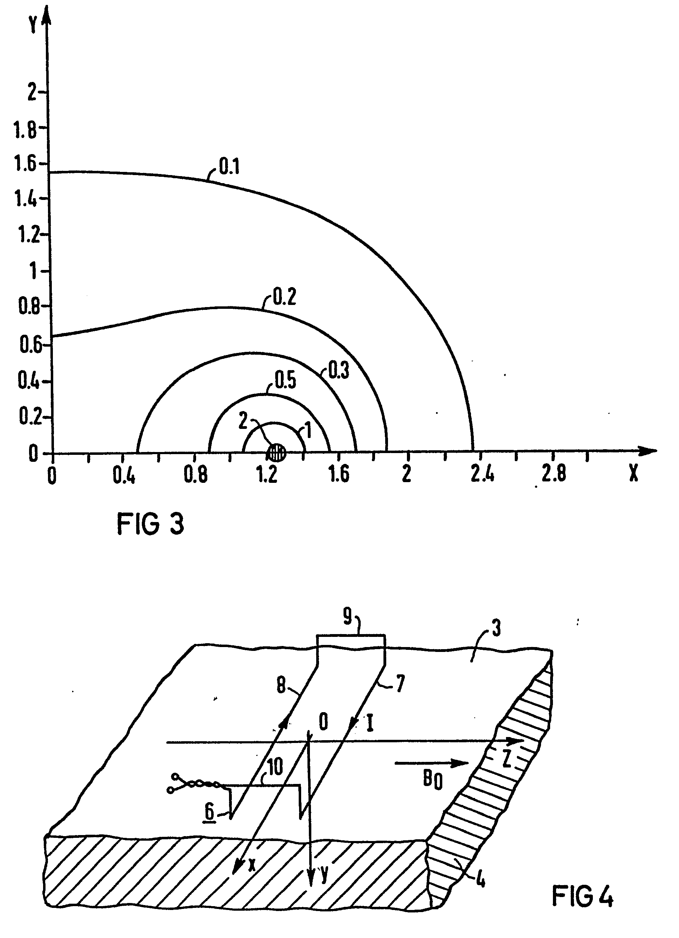

Da das hochfrequente Wechselfeld der Ringspule 2 mit der Feldstärke $B_1$ von dem ganz wesentlich stärkeren magnetischen Grundfeld $\vec{B_0}$ überlagert wird, ergibt sich, dass die Linien konstanter wirksamer Wechselfeldstärke $B_1$ in der y-z-Ebene $E_{yz}$ von den Linien in der x-y-Ebene $E_{xy}$ in komplizierter Weise verschieden sind. Die sich in diesen Transversalebenen für die Anordnung nach Fig. 1 ergebenden Feldlinien sind in den Diagrammen der Fig. 2 und 3 in willkürlichen Einheiten nebeneinandergestellt. Dabei sind die ermittelten relativen Feldstärkenverhältnisse an den jeweiligen Kurven angegeben. Wie insbesondere aus dem Diagramm der Fig. 3 ohne weiteres ersichtlich ist, lässt der Kurvenverlauf keine eindeutige räumliche Zuordnung der Signalquelle zu.

Diese Schwierigkeit wird mit der erfindungsgemässen Ausgestaltung der Hochfrequenz-Spulenwicklung ganz wesentlich verringert. Ein Ausführungsbeispiel einer derartigen Spulenwicklung geht aus der Fig. 4 hervor, wobei mit Fig. 1 übereinstimmende Teile mit den gleichen Bezugszeichen versehen sind. Diese mit 6 bezeichnete Spulenwicklung ist auf dem zu untersuchenden Körperteil 4 aufzubringen. Hierunter wird definitionsgemäss sowohl die Anordnung der Spulenwicklung unmittelbar auf der Körperoberfläche 3 als auch in geringer Entfernung von beispielsweise einigen Zentimetern über derselben verstanden. Die Hochfrequenz-Spulenwicklung 6 hat erfindungsgemäss einen Aufbau in Form eines langgestreckten Rechteckes, d.h. sie weist zwei parallele Längsleiterstücke 7 und 8 auf, zwischen denen Querleiterstücke 9 und 10 verlaufen. Die Spulenwicklung 6 ist dabei so bezüglich des magnetischen Grundfeldes $\vec{B_0}$ ausgerichtet, dass ihre Längsleiterstücke 7 und 8 zumindest annähernd rechtwinklig zu diesem Feld verlaufen. Die gegenüber den Längsleiterstücken 7 und 8 wesentlich kürzeren Querleiterstücke 9 und 10 liegen somit im wesentlichen parallel zu diesem Grundfeld. Vorteilhaft sind die Längsleiterstücke 7 und 8 mindestens dreimal länger als die Querleiterstücke 9 und 10. Um Endeffekte der Spulenwicklung 6 zu reduzieren, sind die Querleiterstücke 9 und 10 von der Körperoberfläche 3 abgehoben, so dass sie sich in grösserer Entfernung zu der Signalquelle in dem Körperteil 4 befinden als vergleichsweise die beiden Längsleiterstücke 7 und 8. Neben dieser in der Figur dargestellten Massnahme zur Reduzierung von Endeffekten können auch andere Massnahmen wie z.B. eine hochfrequenzmässige Abschirmung der Querleiterstücke vorgesehen werden.

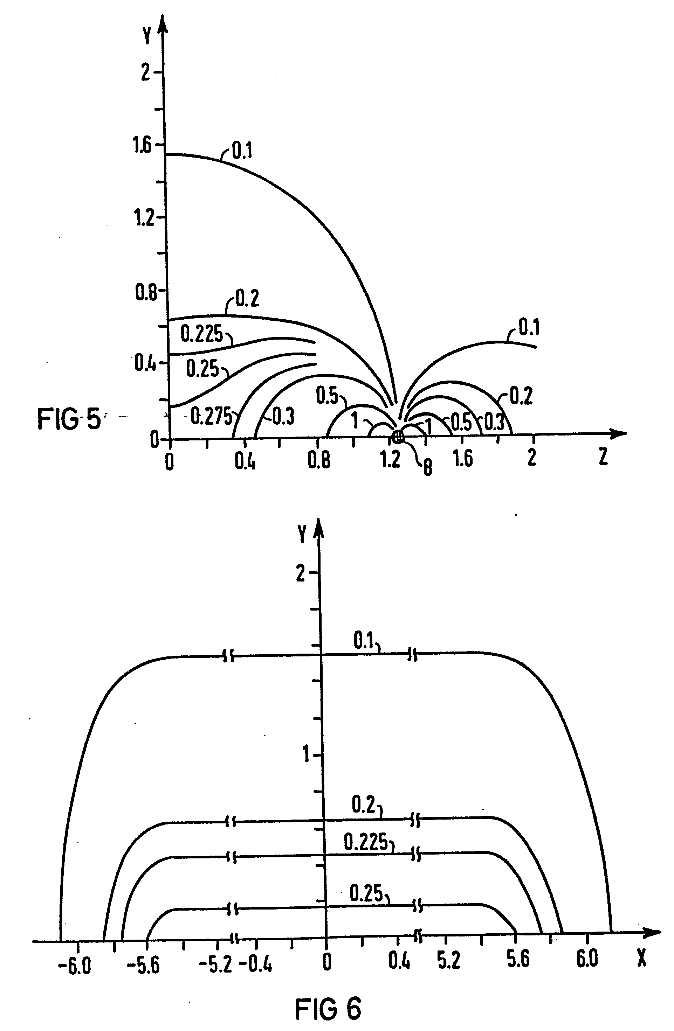

Mit der erfindungsgemässen Ausgestaltung der Spulenwicklung 6 wird im Vergleich zu einer ringförmigen Ausbildung der Spulenwicklung eine bessere Richtcharakteristik erreicht. Dies lässt sich aus den beiden Diagrammen der Fig. 5 und 6 entnehmen, welche den Diagrammen der Fig. 2 und 3 entsprechen. Während sich gemäss Fig. 5 ein Verlauf der Linien konstanter wirksamer magnetischer Wechselfeldstärke in der y-z-Ebene ergibt, der im wesentlichen die Gestalt der Linien des Diagramms nach Fig. 2 hat, lässt der Verlauf der Linien des Diagramms nach Fig. 6 eine bessere Aussage über die Lage der Signalquelle in der y-z-Ebene zu, da nämlich, abgesehen von Endeffekten, in jeder y-z-Ebene annähernd gleiche Feldverhältnisse herrschen.

Bei dem Ausführungsbeispiel der erfindungsgemässen Spulenwicklung nach Fig. 4 wurde davon ausgegangen, dass die Wicklung nur aus einer einzigen Leiterschleife gebildet wird. Selbstverständlich kann die Wicklung auch mehrere eine gemeinsame Schleife bildende Windungen eines Leiters enthalten.

**Patentansprüche**

1. Einrichtung zur Erzeugung eines magnetischen Hochfrequenz-Feldes und/oder zum Empfangen von entsprechenden Hochfrequenz-Signalen in einer Kernspinresonanz-Apparatur, insbesondere der medizinischen Technik, mit einer Hochfrequenz-Spulenwicklung (6), welche innerhalb eines zumindest teilweise homogenen Magnetfeldbereiches des von einem Grundfeldmagneten erzeugten, längs einer Achse orientierten Magnetfeldes ($\vec{B_0}$) entweder unmittelbar auf einem zu untersuchenden Körper oder Körperteil (4) oder zumindest in der Nähe desselben anzuordnen ist, dadurch gekennzeichnet, dass die Hochfrequenz-Spulenwicklung (6) im wesentlichen eine rechteckige Gestalt aufweist, wobei deren mindestens zwei parallel verlaufende Längsleiterstücke (7, 8) wesentlich länger ausgebildet sind als die sie verbindenden, dazu quer verlaufenden Querleiterstücke (9, 10), und dass die Längsleiterstücke (7, 8) zumindest weitgehend senkrecht zur Orientierungsrichtung des Magnetfeldes ($\vec{B_0}$) des Grundfeldmagneten angeordnet sind.

2. Einrichtung nach Anspruch 1, dadurch gekennzeichnet, dass das kürzeste Längsleiterstück (7, 8) der Hochfrequenz-Spulenwicklung (6) mindestens dreimal länger als sein jeweils zugeordnetes Querleiterstück (9, 10) ist.

3. Einrichtung nach Anspruch 1 oder 2, dadurch gekennzeichnet, dass die Querleiterstücke (9, 10) nach aussen hin hochfrequenzmässig abgeschirmt sind.

4. Einrichtung nach Anspruch 1 oder 2, dadurch gekennzeichnet, dass die Querleiterstücke (9, 10) in einem grösseren Abstand von der Oberfläche des zu untersuchenden Körperteiles (4) angeordnet sind als die Längsleiterstücke (7, 8).

## Claims

1. A device for creating a high-frequency magnetic field and/or receiving corresponding high-frequency signals in nuclear magnetic resonance apparatus, particularly for use in the medical technology field, with a high-frequency coil (6), arranged within an at least partly homogeneous zone of the magnetic field created by a basic field magnetic and aligned on an axis directly on or close to a body or a part of a body which is to be examined (4), characterised in that the high-frequency coil (6) has an essentially rectangular shape, with at least two longitudinal conductor portions (7, 8), considerably longer than the transverse conductor portions (9, 10) which extend transversely between them to connect them to the longitudinal conductor elements (7, 8) being arranged, to a large extent at least, perpendicular to the orientation of the magnetic field ($\vec{B_0}$) of the basic field magnet.

2. A device as claimed in Claim 1, characterised in that the shortest longitudinal conductor portion (7, 8) of the high-frequency coil (6) is three times longer than the transverse portion (9, 10) assigned to it.

3. A device as claimed in Claim 1 or Claim 2, characterised in that the transverse conductor portions (9, 10) are shielded against rf-fields.

4. A device as claimed in Claim 1 or Claim 2, characterised in that the transverse conductor portions (9, 10) are set at a greater distance from the surface (3) of the part of the body to be examined (4) than are the longitudinal conductor portions (7, 8).

## Revendications

1. Dispositif de production d'un champ magnétique de haute fréquence et/ou de réception de signaux correspondants de haute fréquence dans un appareil à résonance magnétique nucléaire, notamment en technique médical, comprenant un enroulement en bobine (6) de haute fréquence, qui est disposé, dans une région au moins partiellement homogène du champ magnétique ($\vec{B_0}$) produit par un aimant inducteur de base et orienté le long d'un axe, soit directement sur un corps ou sur une partie du corps (4) à étudier, soit au moins à proximité de celui-ci, caractérisé en ce que l'enroulement en bobine (6) de haute fréquence affecte une forme essentiellement rectangulaire, dont au moins deux tronçons conducteurs longitudinaux (7, 8) parallèles sont sensiblement plus longs que les tronçons conducteurs transversaux (9, 10) qui les relient et qui leur sont transversaux, et en ce que les tronçons conducteurs longitudinaux (7, 8) sont disposés au moins approximativement perpendiculairement à la direction du champ magnétique ($\vec{B_0}$) de l'aimant inducteur de base.

2. Dispositif suivant la revendication 1, caractérisé en ce que le tronçon conducteur longitudinal (7, 8) le plus court de l'enroulement en bobine (6) en haute fréquence, est au moins trois fois plus long que son tronçon conducteur transversal (9, 10) associé.

3. Dispositif suivant la revendication 1 ou 2, caractérisé en ce que les tronçons conducteurs transversaux (9, 10) sont blindés vers l'extérieur du point de vue de la haute fréquence.

4. Dispositif suivant la revendication 1 ou 2, caractérisé en ce que les tronçons conducteurs transversaux (9, 10) sont disposés à une distance plus grande de la surface (3) de la partie du corps à étudier (4) que les tronçons conducteurs longitudinaux (7, 8).

FIG 1

FIG 2

FIG 3

FIG 4

FIG·5

FIG 6